# EUROPÄISCHE PATENTANMELDUNG

(11) **EP 3 882 980 A2**
(43) Veröffentlichungstag der Anmeldung: **22.09.2021**
(21) Anmeldenummer: 21000070.9
(22) Anmeldetag: 12.03.2021
(51) Int. Cl.: H01L 29/861, H01L 29/04, H01L 29/06, H01L 29/20, H01L 29/205, H01L 23/29, H01L 23/31, H01L 21/329, H01L 29/40

(54) **STAPELFÖRMIGE HOCHSPERRENDE III-V-HALBLEITERLEISTUNGSDIODE**

(30) Priorität: 20.03.2020 DE 102020001838
(71) Anmelder: AZUR SPACE Solar Power GmbH, 74072 Heilbronn (DE)
(72) Erfinder: Fuhrmann, Daniel, 74081 Heilbronn (DE); Keller, Gregor, 74080 Heilbronn (DE); Strobl, Gerhard, 70439 Stuttgart (DE); Wächter, Clemens, 74348 Lauffen am Neckar (DE)
(74) Vertreter: Koch Müller Patentanwaltsgesellschaft mbH

(57) **Zusammenfassung**

Stapelförmige hochsperrende III-V-Halbleiterleistungsdiode, aufweisend ein erste metallische Anschlusskontaktschicht, eine hochdotierte erste Halbleiterkontaktschicht, ein niedrig dotiertes Driftgebiet mit einer Schichtdicke von 10 µm - 200 µm und eine zweite metallische Anschlusskontaktschicht, wobei die vorgenannten Gebiete und Schichten in der genannten Reihenfolge angeordnet sind, die erste Halbleiterkontaktschicht als Mesa-Struktur ausgebildet ist, eine Unterseite der ersten Halbleiterkontaktschicht auf oder oberhalb eines ersten Oberflächenabschnitts des Driftgebiets angeordnet ist, eine Unterseite der ersten metallischen Anschlusskontaktschicht stoffschlüssig mit einer Oberseite der ersten Halbleiterkontaktschicht verbunden Ist und die zweite Anschlusskontaktschicht unterhalb einer Unterseite der des Driftgebiets angeordnet ist, wobei die III-V-Halbleiterleistungsdiode eine dotierte III-V-Halbleiterpassivierungsschicht aufweist, die III-V-Halbleiterpassivierungsschicht in einem ersten Abstand von mindestens 0,1 µm oder mindestens 10 µm zu der hochdotierten ersten Halbleiterkontaktschicht auf der Oberseite des Driftgebiets angeordnet, mit der Oberseite des Driftgebiets stoffschlüssig verbunden ist und eine sich von einer Energiebandlücke des Driftgebiets unterscheidende Energiebandlücke aufweist.

## Beschreibung

Die Erfindung betrifft eine stapelförmige hochsperrende III-V-Halbleiterleistungsdiode.

Aus "GaAs Power Devices" von German Ashkinazi, ISBN 965-7094-19-4, Seite 8 und 9 ist eine hochspannungsfeste Halbleiterleistungsdiode aus GaAs mit p⁺ - n - n⁺ Struktur bekannt. Auf den Seiten 23 bis 26 werden GaAs Schottky-Dioden beschrieben.

Weitere hochspannungsfeste III-V- Halbleiterleistungsdioden und entsprechende Herstellungsverfahren sind auch aus den Druckschriften DE 10 2016 013 540 A1, DE 10 2016 013 541 A1, DE 10 2016 015 056 A1, DE 10 2017 002 935 A1 und DE 10 2017 002 936 A1 bekannt.

Nachteilig an den beschriebenen Strukturen sind die Rest- bzw. Leckströme, die bei einem Betrieb in Sperrrichtung, insbesondere über die Ränder der planaren p-n Übergänge bzw. der Mesa-Strukturen auftreten.

Vor diesem Hintergrund besteht die Aufgabe der Erfindung darin, eine Vorrichtung anzugeben, die den Stand der Technik weiterbildet.

Die Aufgabe wird durch eine hochsperrende III-V-Halbleiterleistungsdiode mit den Merkmalen des Patentanspruchs 1 gelöst. Vorteilhafte Ausgestaltungen der Erfindung sind Gegenstand von Unteransprüchen.

Gemäß dem Gegenstand der Erfindung wird eine stapelförmige hochsperrende III-V-Halbleiterleistungsdiode bereitgestellt.

Die stapelförmige hochsperrende III-V-Halbleiterleistungsdiode weist eine zumindest gebietsweise ausgebildete erste metallische Anschlusskontaktschicht, ein erstes hochdotiertes Halbleiterkontaktgebiet, ein Driftgebiet und eine zweite metallische Anschlusskontaktschicht auf, wobei die vorgenannten Gebiete und Schichten in der genannten Reihenfolge angeordnet sind.

Die hochdotierte erste Halbleiterkontaktschicht weist einen ersten Leitfähigkeitstyp mit einer Dotierstoffkonzentration von mindestens 1•10¹⁸ cm⁻³ oder von mindestens 5•10¹⁸ cm⁻³, eine erste Gitterkonstante auf. Eine Schichtdicke der Halbleiterkontaktschicht beträgt beispielsweise zwischen 50 nm und 5 µm oder zwischen 500 nm und 15 µm oder von 10 µm und 100 µm.

Die erste Halbleiterkontaktschicht ist als Mesa-Struktur mit einer Unterseite, einer Oberseite, einer Mesa-Breite und einer Mesa-Höhe ausgebildet.

Die Unterseite der ersten Halbleiterkontaktschicht ist auf oder oberhalb eines ersten Oberflächenabschnitts der Oberseite des Driftgebiets mit einer mit der Mesa-Breite übereinstimmende Breite angeordnet.

Das Driftgebiet weist eine erste Energiebandlücke, die erste Gitterkonstante und einen zweiten Leitfähigkeitstyp oder den ersten Leitfähigkeitstyp auf, wobei eine Dotierstoffkonzentration von 8•10¹¹ bis 8•10¹⁴ cm⁻³ oder von 8•10¹² bis 8•10¹⁴ cm⁻³ oder von 8•10¹² bis 1•10¹⁵ cm⁻³ beträgt.

Das Driftgebiet weist außerdem eine Schichtdicke von 10 µm - 100 µm oder von 10 µm bis 200 µm auf.

In einer ersten Ausführungsform weist das Driftgebiet eine gleichmäßige Dotierstoffkonzentration über die Höhe bzw. Schichtdicke des Driftgebiets auf. In einer anderen Ausführungsform ist die Dotierstoffkonzentration über die Dicke des Driftgebiets unterschiedlich hoch.

Eine Unterseite der ersten metallischen Anschlusskontaktschicht ist stoffschlüssig mit der Oberseite der ersten Halbleiterkontaktschicht verbunden und die zweite metallische Anschlusskontaktschicht ist unterhalb einer Unterseite des Driftgebiets angeordnet.

Die hochsperrende III-V-Halbleiterleistungsdiode weist außerdem eine III-V-Halbleiterpassivierungsschicht mit der ersten Gitterkonstanten auf, wobei die III-V-Halbleiterpassivierungsschicht den ersten oder den zweiten Leitfähigkeitstyp und jeweils eine Dotierstoffkonzentration in einem Bereich zwischen 1•10¹⁴ cm⁻³ und 5•10¹⁸ cm⁻³ oder zwischen 1•10¹⁴ cm⁻³ und 1•10¹⁹ cm⁻³ aufweist.

Die III-V-Halbleiterpassivierungsschicht weist außerdem eine zweite Energiebandlücke auf. Vorzugsweise unterscheidet sich die zweite Energiebandlücke von der ersten Energiebandlücke des Driftgebiets. Besonders bevorzugt ist die zweite Energiebandlücke der III-V-Halbleiterpassivierungsschicht größer als die erste Energiebandlücke des Driftgebiets.

Die III-V-Halbleiterpassivierungsschicht ist in einem ersten Abstand von mindestens 0,1 µm oder von mindestens 0,5 µm oder von mindestens 1 µm oder von mindestens 2 µm oder von mindestens 10 µm oder von mindestens 20 µm oder von mindestens 40 µm und vorzugsweise maximal 500 µm oder vorzugsweise maximal 100 µm oder vorzugsweise maximal 50 µm zu der Mesa-Struktur der ersten Halbleiterkontaktschicht auf der Oberseite des Driftgebiets angeordnet und mit der Oberseite des Driftgebiets stoffschlüssig verbunden.

In einer Weiterbildung weist die stapelförmige hochsperrende III-V-Halbleiterleistungsdiode eine weitere Passivierungsschicht auf, wobei die weitere Passivierungsschicht vorzugsweise Si₃N₄ aufweist oder aus Si₃N₄ besteht.

Es sei angemerkt, dass die metallischen Anschlusskontaktschichten jeweils elektrisch sehr gut leitfähig sind. Vorzugsweise bestehen die metallischen Anschlusskontaktschichten aus einer oder mehreren Metallschichten, wobei die Metallschichten vorzugsweise Ge und/oder Au und/oder Pd und/oder Ag und/oder Zn umfassen.

Die metallischen Anschlusskontaktschichten stellen zu der hochdotierten erste Halbleiterkontaktschicht sowie zu einer weiteren dotierten Halbleiterschicht, z.B. einer zweiten hochdotierten Halbleiterkontaktschicht oder dem Driftgebiet, einen elektrisch niederohmigen Kontakt her.

Es versteht sich, dass der Halbleiterkontaktbereich sowie die weitere Halbleiterschicht hierfür jeweils unmittelbar an die entsprechende metallische Anschlusskontaktschicht angrenzen.

Des Weiteren versteht es sich, dass die Anschlusskontaktschichten vorzugsweise mittels Bonddrähten mit Kontaktfingern, den sogenannten Pins, verschaltet sind, indem die Halbleiterleistungsdioden auf einem Träger beispielsweise in Form eines Leadframes angeordnet sind.

Es versteht sich auch, dass die Halbleiterleistungsdiode mit einer n-auf-p oder einer p-auf-n Struktur ausgebildet sein kann. Entsprechend ist entweder der erste Leitfähigkeitstyp n und der zweite Leitfähigkeitstyp p oder vice versa.

Das Driftgebiet und die III-V-Halbleiterpassivierungsschicht der III-V-Halbleiterleistungsdiode sowie gegebenenfalls eine zweite Halbleiterkontaktschicht und/oder weitere Halbleiterzwischenschichten sind vorzugsweise epitaktisch erzeugt.

Es wird angemerkt, dass es sich auch bei dem Driftgebiet um eine Halbleiterschicht handelt.

In einer Ausführungsform wird die erste Halbleiterschicht der Halbleiterleistungsdiode, z.B. das Driftgebiet oder eine zweite Halbleiterkontaktschicht, auf einem die erste Gitterkonstante aufweisenden Aufwachssubstrat, z.B. einem GaAs-Substrat, erzeugt.

Alternativ wird ein Substrat mit einer zweiten Gitterkonstanten, z.B. ein Ge-Substrat, und eine den Gitterkonstantenunterschied ausgleichende Pufferschichtstruktur als Aufwachssubstrat verwendet.

Das Aufwachssubstrat wird in einem späteren Herstellungsschritt entweder vollständig oder teilweise, z.B. durch Schleifen und / oder Ätzen und / oder andere Prozesse, z.B. Ablösen, wieder entfernt.

Die Mesa-Struktur ist vorzugsweise durch epitaktisches Wachstum sowie zwei Ätzschritte erzeugt. Vorzugsweise sind die Ätzschritte als Trockenätzschritte und / oder als Nassätzschritte ausgebildet.

Der erste Ätzschritt erzeugt eine durch die epitaktisch erzeugte III-V-Halbleiterpassivierungsschicht bis zu dem Driftgebiet reichende Lücke in der Halbleiterpassivierungsschicht. Anders ausgedrückt die Passivierungsschicht ist im Bereich der Lücke weggeätzt.

Anschließend werden der Mesa-Struktur entsprechende Schichten, also insbesondere eine der ersten Halbleiterkontaktschicht entsprechende Schicht, in einem Epitaxie-Schritt aufgewachsen und die erste metallische Anschlusskontaktschicht aufgebracht. Nach dem Metallisierungsschritt folgt der zweite Ätzschritt, der die Mesa-Struktur freilegt.

Es versteht sich, dass insbesondere durch den zweiten Ätzschritt Gräben in einem die Mesa-Struktur umgebenden Bereich des Driftgebiet entstehen, wenn In einer Ausführungsform keine oder nur eine sehr geringe Ätz-Selektivität zwischen der Mesa-Struktur, also den Schichten der Mesa-Struktur, und dem Driftgebiet besteht.

Ebenso versteht es sich, dass die Mesa-Breite über die Höhe der Mesa-Struktur variieren kann. Insbesondere weist die Mesa-Struktur gemäß einiger Ausführungsformen aufgrund von einem oder mehreren Ätzprozessen während der Herstellung Unterätzungen auf.

Alternativ oder ergänzend sind eine oder mehrere Schichten der Halbleiterleistungsdiode mittels eines Wafer-Bond miteinander verbunden.

Es versteht sich auch, dass die hochsperrende III-V-Halbleiterleistungsdiode vorwiegend aus Elementen der III. und V. Hauptgruppe besteht, d.h., dass die Halbleiterbereiche bzw. Halbleiterschichten, inklusive des als Halbleiterschicht ausgebildeten Driftgebiets, oder zumindest ein Großteil der Halbleiterbereiche bzw. Halbleiterschichten der hochsperrenden III-V-Halbleiterleistungsdiode aus III-V-Materialien, z.B. GaAs, AlGaAs, InGaP, GaAsP, InGaAs oder InP bestehen.

Gemäß von Ausführungsformen weist die hochsperrende III-V-Halbleiterleistungsdiode zusätzlich eine oder mehrere Halbleiterschichten aus anderen Halbleitermaterialien und/oder zusätzlich eine oder mehrere Schichten aus anderen nicht-Halbleiter-Materialien, z.B. eine Nitridschicht oder eine Oxidschicht oder eine Oxinitridschicht oder eine Polyimidschicht als weitere Passivierungsschicht, auf.

Außerdem versteht es sich, dass ein aus einem III-V-Material bestehendes Gebiet bzw. Schicht nur im Wesentlichen aus III-V-Material bestehen muss bzw. neben einem III-V-Material, also einem Material, welches ein oder mehrere Elemente der III. sowie der V. Hauptgruppe umfasst, gegebenenfalls noch Verunreinigungen und/oder Dotierstoffe aufweist.

Entsprechendes gilt für ein aus GaAs oder einer anderen ausdrücklich genannten Materialkombination bestehendes Halbleitergebiet bzw. bestehende Halbleiterschicht.

Weist eine Schicht eine ausdrücklich genannte Materialkombination auf, so wird damit ausgedrückt, dass das Material der Schicht im Wesentlichen aus einer Verbindung der ausdrücklich genannten Materialien und gegebenenfalls weiteren Elementen der III. und/oder V. Hauptgruppe besteht. Eine GaAs aufweisende Schicht kann also beispielsweise eine InGaAs-Schicht sein.

Es sei angemerkt, dass mit dem Begriff "hochsperrend" ausgedrückt wird, dass die Diode im Rückwärtsbetrieb Durchbruchspannungen von mindestens 200 V erreicht.

In einer Ausführungsform bestehen das Driftgebiet und die erste Halbleiterkontaktschicht sowie gegebenenfalls unterhalb des Driftgebiets folgende Halbleiterschichten aus GaAs oder oder aus InGaAs oder weisen einen Indium-Gehalt von höchstens 30% auf, da GaAs und InGaAs eine besonders hohe Ladungsträgerbeweglichkeit aufweisen.

Die III-V-Halbleiterpassivierungsschicht besteht vorzugsweise aus InGaP oder InAlP oder InAlGaP oder AlGaAs. Höchst bevorzugt weist die III-V-Halbleiterpassivierungsschicht eine höhere Energiebandlücke als das Driftgebiet auf.

Niedrig dotierte dicke Schichten, wie das erfindungsgemäße Driftgebiet, lassen sich inzwischen beispielsweise mittels MOVPE abscheiden, wodurch der erfindungsgemäße Schichtstapel auf einfache Weise erzeugt werden kann.

Durch die III-V-Halbleiterpassivierungsschicht werden Leckströme im Randbereich und über die Oberfläche der Halbleiterleistungsdiode bzw. über den Rand verlaufende Strompfade unterdrückt. Untersuchungen haben gezeigt, dass die Durchbruchspannung von dem ersten Abstand zwischen der III-V-Halbleiterpassivierungsschicht und der ersten Halbleiterkontaktschicht beeinflusst wird.

Mit der erfindungsgemäßen hochsperrenden Halbleiterleistungsdiode lassen sich Durchbruchfeldstärken von bis zu 40V/µm und sehr zuverlässig Durchbruchfeldstärken von über 20 V/µm erreichen. Die erfindungsgemäße Halbleiterstruktur eignet sich daher besonders als Freilaufdiode, also zum Einsatz als sogenannte Schutzdiode.

Ein Vorteil der erfindungsgemäßen Halbleiterstruktur sind ein besonders geringer Sperrstrom und eine hohe Durchbruchspannung. Insbesondere weist die Durchbruchkennlinie einen idealen Verlauf auf.

Bei der erfindungsgemäße Halbleiterstruktur treten an der Grenzfläche zwischen dem Driftgebiet und der III-V-Halbleiterpassivierungsschicht im Vergleich zu einer Grenzfläche eines Driftgebiets zu einer üblichen Passivierungsschicht, wie z.B. Si₃N₄ oder SiO₂, deutlich weniger Rekombinationen auf, wodurch die Leckströme wesentlich reduziert werden. Insbesondere werden durch die III-V-Halbleiterpassivierungsschicht im Vergleich zu einer üblichen SiN oder SiO Passivierungsschicht Oberflächenzustände besser abgesättigt.

Außerdem ermöglicht eine im Vergleich zum Driftgebiet erhöhte Energlebandlücke der Halbleiterpassivierungsschicht das Fernhalten der Ladungsträger von der Oberfläche, wodurch Leckströme besonders effektiv reduziert werden.

Weiterhin lassen sich mit der erfindungsgemäßen Halbleiterstruktur insbesondere hochsperrende Dioden mit im Vergleich zu Si- oder SiC-basierten Lösungen deutlich reduzierter Kapazität herstellen. Durch die geringere Kapazität verbessert sich das Verhalten der Bauteile in der Anwendung insbesondere bei Umschaltvorgängen, wodurch insgesamt die Effizienz von Leistungsmodulen deutlich verbessert wird und vor allem im Vergleich zu Si-Lösungen höhere Schaltfrequenzen und kleinere Bauteile und damit kleinere Leistungsmodule realisiert werden können.

Auch lassen sich mit den III-V Halbleiterleistungsdioden im Vergleich zu Sibasierten Dioden höheren Temperaturen an dem p-n-Übergang erreichen, ohne dass die III-V Halbleiterleistungsdioden zerstört werden. So lassen sich III-V Halbleiterleistungsdioden auch in heißen Umgebungen mit Temperaturen von bis zu 300°C einsetzten.

Ein weiterer Vorteil im Vergleich zu SiC-Bauelementen ist, dass sich III-V Halbleiterleistungsdioden wesentlich kostengünstiger herstellen lassen als Halbleiterstrukturen aus SiC mit vergleichbaren elektrischen Eigenschaften.

Angemerkt wird außerdem, dass die Begriffe "unten" und "oben" bzw. "unterhalb" und "oberhalb" lediglich dazu dienen, die Anordnung der einzelnen Schichten und Gebiete zueinander zu beschreiben und keine absolute Richtung angeben.

In einer ersten Ausführungsform weist die III-V-Halbleiterpassivierungsschicht eine Schichtdicke von 0,02 µm - 1 µm auf oder von 0,02 - 10 µm auf. Vorzugsweise weist die III-V-Halbleiterpassivierungsschicht InGaP oder AlGaAs oder InGaAsP oder InAlP oder InAlGaP auf oder besteht aus InGaP oder aus AlGaAs oder aus InGaAsP oder aus InAlP oder aus InAlGaP.

In einer anderen Ausführungsform beträgt der erste Abstand der III-V-Halbleiterpassivierungsschicht zu der ersten Halbleiterkontaktschicht mindestens 0,1% oder mindestens 2% oder mindestens 10% oder mindestens 50% oder mindestens 75% der Schichtdicke des Driftgebiets. Es versteht sich, dass der erste Abstand sich nach der Sperrspannung richtet. Je größer die Sperrspannung, umso größer muss der erste Abstand sein. Hieraus ergibt sich entsprechend ein Zusammenhang zwischen dem Abstand und der Schichtdicke des Driftgebiets.

In einer weiteren Ausführungsform umschließt die III-V-Halbleiterpassivierungsschicht in einer Projektion senkrecht zu der Oberseite der ersten Halbleiterkontaktschicht die erste Halbleiterkontaktschicht vollständig.

Die III-V-Halbleiterpassivierungsschicht weist also eine von der Oberseite der Halbleiterpassivierungsschicht bis zu der Unterseite reichende Durchgangsöffnung auf und die erste Halbleiterkontaktschicht ist so innerhalb dieser Durchgangsöffnung der Halbleiterpassivierungsschicht angeordnet, dass ein Abstand eines Randes der ersten Halbleiterkontaktschicht zu einem Rand der Durchgangsöffnung der Passivierungsschicht immer größer oder gleich dem ersten Abstand ist.

In einer weiteren Ausführungsform weist die III-V-Halbleiterpassivierungsschicht einen dem Driftgebiet entsprechenden Leitfähigkeitstyp auf.

Alternativ weist das Driftgebiet den ersten Leitfähigkeitstyp und die III-V-Halbleiterpassivierungsschicht den zweiten Leitfähigkeitstyp auf, wobei eine zumindest gebietsweise ausgebildete dritte metallische Anschlusskontaktschicht stoffschlüssig mit einer Oberseite der III-V-Halbleiterpassivierungsschicht verbunden ist.

In einer anderen Ausführungsform ist die III-V-Halbleiterpassivierungsschicht und/oder die erste Halbleiterkontaktschicht und/oder das Driftgebiet jeweils epitaktisch auf einer vorausgehenden Schicht der hochsperrenden III-V-Halbleiterleistungsdiode erzeugt.

In einer weiteren Ausführungsform weist die erste Halbleiterkontaktschicht und das Driftgebiet und/oder eine zweite Halbleiterkontaktschicht GaAs auf oder besteht aus GaAs.

In einer weiteren Weiterbildung weist die Mesa-Struktur einen kreisförmigen oder einen ovalen oder einen mehreckigen Umfang oder einen rechteckigen Umfang mit abgerundeten Kanten auf. Es versteht sich, dass der Umfang durch die umlaufenden Seitenflächen gegeben ist, d.h. die Mesa-Struktur weist in einer Projektion senkrecht zu einer Oberseite der Mesa-Struktur eine kreisförmige oder ovale oder mehreckige Form oder eine rechteckige Form mit abgerundeten Kanten auf.

In einer anderen Ausführungsform ist der erste Leitfähigkeitstyp n und der zweite Leitfähigkeitstyp p ist oder der erste Leitfähigkeitstyp ist p und der zweite Leitfähigkeitstyp n.

In einer weiteren Weiterbildung weist das stapelförmige hochsperrende III-V-Halbleiterbauelement eine Pufferschicht auf, wobei die metamorphe Pufferschicht unterhalb der Unterseite des Driftgebiets und oberhalb der zweiten metallischen Anschlusskontaktschicht angeordnet ist und an einer dem Driftgebiet zugewandten Oberseite die erste Gitterkonstante und an einer Unterseite eine von der ersten Gitterkonstanten abweichende zweite Gitterkonstante aufweist.

Vorzugsweise weist die metamorphe Pufferschicht eine Dicke zwischen 0,5 µm und 5 µm und eine Dotierung zwischen 1•10¹⁷ bis 1•10¹⁹ cm⁻³ auf. Es versteht sich, dass die metamorphe Pufferschicht wenigstens drei Halbleiterschichten umfasst, wobei sich die Gitterkonstante der metamorphen Pufferschicht von Halbleiterschicht zu Halbleiterschicht im Allgemeinen ändert. In einer anderen Ausführungsform variiert die Gitterkonstante der Halbleiterschicht stufenlos zwischen den beiden Gitterkonstanten.

Die metamorphe Pufferschicht kann beispielsweise dazu dienen, das Driftgebiet epitaktisch auf einem Substrat zu erzeugen, welches die zweite Gitterkonstante aufweist. Alternativ ermöglicht die Pufferschicht das Ausbilden einer Halbleiterkontaktschicht aus einem Material mit der zweiten Gitterkonstanten.

Alternativ oder ergänzend weist die hochsperrende III-V-Halbleiterleistungsdiode eine Substratschicht auf, wobei die Substratschicht unterhalb der Unterseite des Driftgebiets und oberhalb der zweiten metallischen Anschlusskontaktschicht angeordnet ist und die erste Gitterkonstante oder eine von der ersten Gitterkonstanten abweichende zweite Gitterkonstante aufweist.

In einer Weiterbildung weist die hochsperrende III-V-Halbleiterleistungsdiode eine zumindest gebietsweise ausgebildete Halbleiterzwischenschicht mit einer Schichtdicke von höchstens 80 µm oder von höchstens 40 µm und mit einer Dotierstoffkonzentration von 8•10¹² - 1•10¹⁶ cm⁻³ auf, wobei die Halbleiterzwischenschicht entweder unterhalb des Driftgebiets und oberhalb einer hochdotierten zweiten Halbleiterkontaktschicht angeordnet ist und den zweiten Leitfähigkeitstyp aufweist oder oberhalb des Driftgebiets und unterhalb der ersten Halbleiterkontaktschicht angeordnet ist und den ersten Leitfähigkeitstyp aufweist.

Beispielsweise ist es im Falle einer n-auf-p Struktur mit einer hoch n-dotierten ersten Halbleiterkontaktschicht, einem schwach n-dotierten Driftgebiet und einer hoch p-dotierten zweiten Halbleiterkontaktschicht vorteilhaft, eine schwächer als die zweite Halbleiterkontaktschicht p-dotierte Halbleiterzwischenschicht zwischen der hoch p-dotierten zweiten Halbleiterkontaktschicht und der schwach n-dotierten Schicht des Driftgebiets anzuordnen, um die Leckströme zu reduzieren und die Durchbruchspannung zu erhöhen.

In einer anderen Ausführungsform weist das Driftgebiet den zweiten Leitfähigkeitstyp auf, wobei die zweite metallische Anschlusskontaktschicht mit der Unterseite des Driftgebiets oder mit einer Unterseite einer unterhalb des Driftgebiets angeordneten Pufferschicht oder mit einer Unterseite einer unterhalb des Driftgebiets angeordneten Substratschicht stoffschlüssig verbunden ist.

In einer Weiterbildung ist eine schwächer als die zweite Halbleiterkontaktschicht dotierte Halbleiterzwischenschicht mit dem ersten Leitfähigkeitstyp oberhalb des Driftgebiets angeordnet.

In einer alternativen Ausführungsform weist die hochsperrende III-V-Halbleiterleistungsdiode eine hochdotierte zweite Halbleiterkontaktschicht des zweiten Leitfähigkeitstyps mit einer Dotierstoffkonzentration von mindestens 1•10¹⁷ cm⁻³ und der ersten Gitterkonstanten oder einer zweiten Gitterkonstanten auf, wobei die zweite Halbleiterkontaktschicht unterhalb des Driftgebiets angeordnet ist und die zweite metallische Anschlusskontaktschicht stoffschlüssig mit einer Unterseite der zweiten Halbleiterkontaktschicht verbunden ist.

Die zweite Halbleiterkontaktschicht weist vorzugsweise eine Schichtdicke von 0,5 µm - 200 µm oder von 10 µm - 600 µm auf.

Außerdem weist die zweite Halbleiterkontaktschicht in einer ersten Ausführungsform die erste Gitterkonstante auf, wobei die Oberseite der zweiten Halbleiterkontaktschicht In einer Weiterbildung mit der Unterseite des Driftgebiets stoffschlüssig verbunden.

Alternativ weist die zweite Halbleiterkontaktschicht die zweite Gitterkonstante auf, wobei zwischen der zweiten Halbleiterkontaktschicht und dem Driftgebiet eine Pufferschicht mit der ersten Gitterkonstanten an einer dem Driftgebiet zugewandten Oberseite und der zweiten Gitterkonstante an einer der zweiten Halbleiterkontaktschicht zugewandten Unterseite angeordnet ist.

In einer anderen Weiterbildung ist die zweite Halbleiterkontaktschicht als Substratschicht oder als Pufferschicht ausgebildet.

In einer anderen Ausführungsform ist die zweite Energiebandlücke der III-V-Halbleiterpassivierungsschicht größer als die erste Energiebandlücke des Driftgebietes.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die laterale und die vertikale Erstreckung sind nicht maßstäblich und weisen, sofern nicht anders angegeben, auch keine ableitbaren geometrischen Relationen zueinander auf. Darin zeigen, die
- Figur 1: eine Schnittansicht einer ersten Ausführungsform einer stapelförmigen hochsperrenden III-V-Halbleiterleistungsdiode,
- Figur 2: eine Aufsicht auf die erste Ausführungsform der stapelförmigen hochsperrenden III-V-Halbleiterleistungsdiode,
- Figur 3: eine Schnittansicht einer zweiten Ausführungsform der stapelförmigen hochsperrende III-V-Halbleiterleistungsdiode,

- Figur 4: eine Schnittansicht einer dritten Ausführungsform der stapelförmigen hochsperrenden III-V-Halbleiterleistungsdiode,
- Figur 5: eine Schnittansicht einer vierten Ausführungsform der stapelförmigen hochsperrenden III-V-Halbleiterleistungsdiode,
- Figur 6: eine Schnittansicht einer fünften Ausführungsform der stapelförmigen hochsperrenden III-V-Halbleiterleistungsdiode.

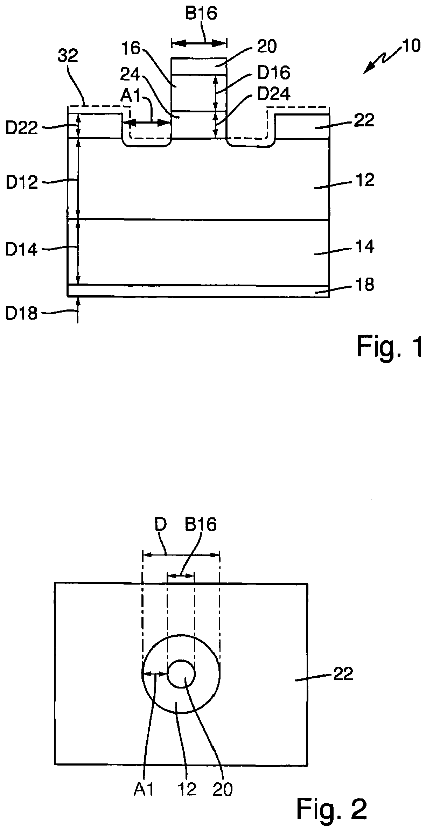

Die Abbildung der Figur 1 zeigt eine stapelförmige hochsperrende III-V-Halbleiterleistungsdiode 10 mit einem Driftgebiet 12, einer ersten Halbleiterkontaktschicht 16, einer zweiten Halbleiterkontaktschicht 14, einer ersten metallischen Anschlusskontaktschicht 20, einer zweiten metallischen Anschlusskontaktschicht 18 sowie einer III-V-Halbleiterpassivierungsschicht 22 und einer Halbleiterzwischenschicht 24.

Das Driftgebiet 12 ist als Halbleiterschicht ausgebildet und weist Dotierstoffe eines ersten oder eines zweiten Leitfähigkeitstyps mit einer Dotierstoffkonzentration von höchstens 10¹⁵ cm⁻³ und eine Schichtdicke D12 von mindestens 10 µm auf.

An einer Unterseite des Driftgebiets 12 folgt stoffschlüssig die hochdotierte zweite Halbleiterkontaktschicht 14 mit Dotierstoffen des zweiten Leitfähigkeitstyps mit einer Dotierstoffkonzentration von mindestens 1•10¹⁷ cm⁻³ und einer Schichtdicke D14 von höchstens 500 µm, z.B. 80 µm.

Die zweite metallische Anschlusskontaktschicht 18 ist als dünne Metallschicht mit einer Schichtdicke D18 auf einer Unterseite der zweiten Halbleiterkontaktschicht 14 ausgebildet.

Die Halbleiterzwischenschicht 24 und die erste Halbleiterkontaktschicht 16 bilden eine Mesa-Struktur auf dem Driftgebiet 12 aus. Die Halbleiterzwischenschicht 24 und die erste Halbleiterkontaktschicht 16 weisen jeweils dieselbe Mesa-Breite B16 oder zumindest im Wesentlichen dieselbe Mesa-Breite auf.

Es versteht sich, dass die Breite der Mesa-Struktur aufgrund von Herstellungsprozessen, insbesondere Ätzprozessen, entlang der Höhe variieren kann. Beispielsweise weist die Mesa-Struktur aufgrund eines Ätzprozesses Unterätzungen auf.

Eine Unterseite der Halbleiterzwischenschicht 24 ist auf einem ersten Oberflächenbereich der Oberseite des Driftgebiets 12 und eine Unterseite der ersten Halbleiterkontaktschicht 16 auf einer Oberseite der Halbleiterzwischenschicht 24 angeordnet.

Die Halbleiterzwischenschicht 24 weist Dotierstoffe eines ersten Leitfähigkeitstyps mit einer Dotierstoffkonzentration von etwa 10¹⁵ cm⁻³ auf. Die erste Halbleiterkontaktschicht 16 weist ebenfalls Dotierstoffe des ersten Leitfähigkeitstyps mit einer Dotierstoffkonzentration von mindestens 1•10¹⁸ cm⁻³ auf.

Die erste metallische Anschlusskontaktschicht 20 ist stoffschlüssig mit einer Oberseite der ersten Halbleiterkontaktschicht 16 verbunden.

In einem Abstand A1 um die Mesa-Struktur, also um den ersten Oberflächenabschnitt, die Halbleiterzwischenschicht und die erste Halbleiterkontaktschicht 16, ist auf der Oberseite des Driftgebiets 12 die III-V-Halbleiterpassivierungsschicht 22 mit einer Schichtdicke D22 angeordnet.

Alle Halbleiterschichten der hochsperrenden III-V-Halbleiterleistungsdiode sind zueinander gitterangepasst, weisen also alle eine erste Gitterkontante auf.

Der erste Leitfähigkeitstyp ist p und der zweite Leitfähigkeitstyp ist n, so dass sich eine p-auf-n Struktur ergibt. Alternativ ist der erste Leitfähigkeitstyp n und der zweite Leitfähigkeitstyp p.

Bevorzugt weist das Driftgebiet den ersten Leitfähigkeitstyp auf, so dass sich der p-n Übergang an der Grenze zwischen dem Driftgebiet und der zweiten hochdotierten Halbleiterkontaktschicht 14 ausbildet.

Alternativ weist das Driftgebiet den zweiten Leitfähigkeitstyp auf, so dass sich der p-n Übergang zwischen der Halbleiterzwischenschicht 24 und dem Driftgebiet 12 ausbildet.

Optional (gestrichelt dargestellt) weist die hochsperrende III-V-Halbleiterleistungsdiode 10 eine weitere Passivierungsschicht 32, z.B. eine Polyimidschicht, auf, wobei die weitere Passivierungsschicht 32 die Oberseite der III-V-Halbleiterpassivierungsschicht 22, eine der Mesa-Struktur zugewandte Seitenfläche der Halbleiterpassivierungsschicht 22 sowie den sich von der Halbleiterpassivierungsschicht 22 bis zu der Mesa-Struktur erstreckenden freiliegenden Oberflächenbereich des Driftgebiets 12 bedeckt.

Es versteht sich, dass die Begriffe "oben", "oberhalb", "unten" und "unterhalb" nur zur Anordnung der einzelnen Gebiete und Schichten relativ zueinander dienen und keine absolute Richtung angeben.

In der Abbildung der Figur 2 ist eine Aufsicht auf die erste Ausführungsform der hochsperrenden III-V-Halbleiterleistungsdiode dargestellt. Im Folgenden werden nur die Unterschiede zu der Abbildung der Figur 1 erläutert.

Die Halbleiterzwischenschicht 24, die erste Halbleiterkontaktschicht 16 sowie die erste metallische Anschlusskontaktschicht 20 weisen jeweils einen kreisförmigen Umfang bzw. Querschnitt mit der Kantenlänge B16 auf.

Die Mesa-Struktur ist von einem freiliegenden Abschnitt der Oberseite des Driftgebiets 12 umgeben, wobei der Abschnitt durchgehend die Breite A1 aufweist. Die restliche Oberfläche des Driftgebiets 12 ist vollständig von der III-V-Halbleiterpassivierungsschicht 22 überdeckt.

Die III-V-Halbleiterpassivierungsschicht 22 weist somit eine runde Aussparung mit einem Durchmesser D auf, wobei der Durchmesser der Summe aus der Kantenlänge B16 der ersten Halbleiterkontaktschicht 16 und der doppelten Breite A1 entspricht.

Nicht dargestellt sind Ausführungsformen mit einem quadratischen, ovalen oder beliebig vieleckigen, z.B. achteckigen Umfang der Mesa-Struktur.

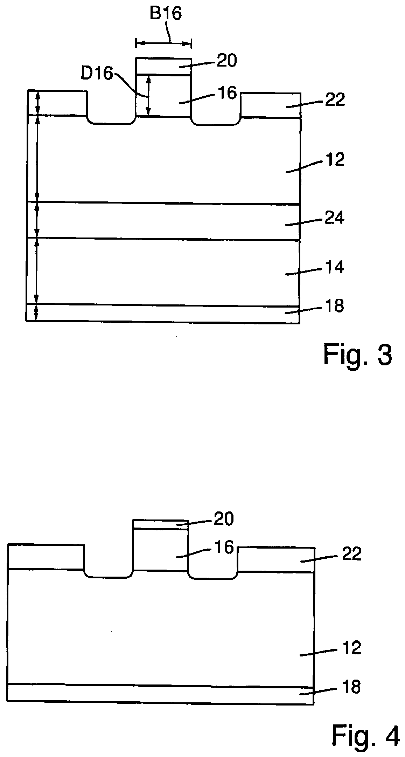

In der Abbildung der Figur 3 ist eine Schnittansicht einer zweiten Ausführungsform der hochsperrenden III-V-Halbleiterleistungsdiode dargestellt. Im Folgenden werden nur die Unterschiede zu der Abbildung der Figur 1 erläutert.

Die Mesa-Struktur wird nur aus der ersten Halbleiterkontaktschicht 16 und der ersten metallischen Anschlusskontaktschicht 20 ausgebildet.

Das Driftgebiet 12 weist bevorzugt den ersten Leitfähigkeitstyp und damit denselben Leitfähigkeitstyp wie die erste Halbleiterkontaktschicht 16 auf.

Die Halbleiterzwischenschicht 24 ist zwischen dem Driftgebiet 12 und der zweiten Halbleiterkontaktschicht 14 angeordnet und weist den zweiten Leitfähigkeitstyp auf.

In der Abbildung der Figur 4 ist eine Schnittansicht einer dritten Ausführungsform der stapelförmigen hochsperrenden III-V-Halbleiterleistungsdiode 10 dargestellt. Im Folgenden werden nur die Unterschiede zu der Abbildung der Figur 1 erläutert.

Die hochsperrende III-V-Halbleiterleistungsdiode 10 weist keine hochdotierte zweite Halbleiterkontaktschicht 14 und keine Halbleiterzwischenschicht 24 auf.

Das Driftgebiet 12 weist bevorzugt den zweiten Leitfähigkeitstyp auf, also einen anderen Leitfähigkeitstyp als die erste Halbleiterkontaktschicht 16. Die erste metallische Anschlusskontaktschicht 18 ist stoffschlüssig mit der Unterseite des Driftgebiets 12 verbunden.

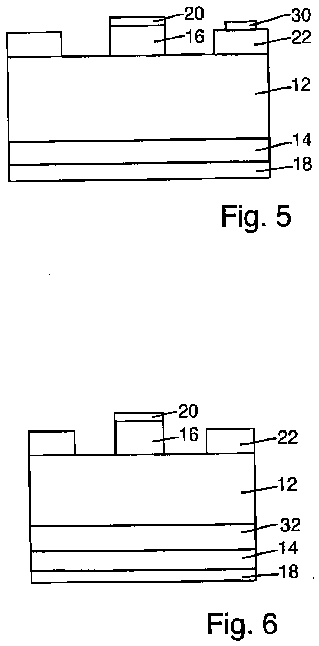

In der Abbildung der Figur 5 ist eine Schnittansicht einer vierten Ausführungsform der stapelförmigen hochsperrenden III-V-Halbleiterleistungsdiode dargestellt. Im Folgenden werden nur die Unterschiede zu der Abbildung der Figur 1 erläutert.

Gemäß der vierten Ausführungsform weist das Driftgebiet 12 den ersten Leitfähigkeitstyp und die III-V-Halbleiterpassivierungsschicht 22 eine sich von dem Leitfähigkeitstyp des Driftgebiets 12 unterscheidenden Leitfähigkeitstyp, also den zweiten Leitfähigkeitstyp, auf.

Zusätzlich ist auf einer Oberseite der III-V-Halbleiterpassivierungsschicht 22 eine zumindest Gebietsweise ausgebildete dritte metallische Anschlusskontaktschicht 30 angeordnet und mit der Oberseite der III-V-Halbleiterpassivierungsschicht 22 stoffschlüssig verbunden.

In der Abbildung der Figur 6 ist eine Schnittansicht einer fünften Ausführungsform der stapelförmigen hochsperrenden III-V-Halbleiterleistungsdiode dargestellt. Im Folgenden werden nur die Unterschiede zu der Abbildung der Figur 1 erläutert.

Die hochsperrende III-V-Halbleiterleistungsdiode 10 weist zusätzlich eine Pufferschicht 32 auf, wobei die Pufferschicht 32 an einer Oberseite die erste Gitterkonstante und an einer Unterseite eine zweite Gitterkonstante aufweist. Die Oberseite der Pufferschicht 32 ist stoffschlüssig mit der Unterseite des Driftgebiets 12 verbunden und die Unterseite der Pufferschicht 32 ist stoffschlüssig mit der Oberseite der zweiten hochdotierten Halbleiterkontaktschicht 14 verbunden. Die zweite Halbleiterkontaktschicht 14 weist die zweite Gitterkonstante auf.

In einer alternativen, nicht dargestellten Ausführungsform weist die hochsperrende III-V-Halbleiterleistungsdiode die Pufferschicht 32, aber keine zweite Halbleiterkontaktschicht 14 auf, so dass die zweite metallische Anschlusskontaktschicht 18 stoffschlüssig mit der Unterseite der Pufferschicht 32 verbunden ist.

Ebenfalls nicht dargestellt sind weitere Ausführungsformen, bei denen die hochsperrende III-V-Halbleiterleistungsdiode 10 statt der Pufferschicht 32 eine Substratschicht mit der ersten Gitterkonstanten oder zusätzlich zu der Pufferschicht 32 und unterhalb der Pufferschicht 32 angeordnet eine Substratschicht mit der zweiten Gitterkonstanten aufweist.

Es versteht sich, dass die beiden vorgenannten Ausführungsformen sowohl mit der hochdotierten zweiten Halbleiterkontaktschicht 14 als auch ohne die zweite Halbleiterkontaktschicht 14 realisiert werden können.

Es versteht sich auch, dass die Ausführungsformen der Figuren 3 und 5 hinsichtlich der Verteilung der Leitfähigkeitstypen, also hinsichtlich der Dotierung bzw. Dotierungstypen der einzelnen Schichten und Bereich mit der Ausführungsform der Figur 6 kompatibel sind. Die einzelnen Varianten sind hier nicht extra dargestellt.

## Patentansprüche

1. Stapelförmige hochsperrende III-V-Halbleiterleistungsdiode (10), aufweisend
- eine zumindest gebietsweise ausgebildete erste metallische Anschlusskontaktschicht (20),
- eine zumindest gebietsweise ausgebildete erste hochdotierte Halbleiterkontaktschicht (16) eines ersten Leitfähigkeitstyps mit einer Dotierstoffkonzentration von mindestens 1•10¹⁸ cm⁻³ und mit einer ersten Gitterkonstanten,
- ein Driftgebiet (12) des ersten Leitfähigkeitstyps oder eines zweiten Leitfähigkeitstyps mit einer Dotierstoffkonzentration von 8•10¹¹ cm⁻³ - 8•10¹⁴ cm⁻³ und einer Schichtdicke (D12) von 10 µm - 200 µm oder von 25 µm - 100 µm und mit der ersten Gitterkonstanten und mit einer ersten Energiebandlücke und
- eine zweite metallische Anschlusskontaktschicht (18), wobei
- die vorgenannten Gebiete und Schichten in der genannten Reihenfolge angeordnet sind,
- die erste Halbleiterkontaktschicht (16) als Mesa-Struktur mit einer Unterseite, einer Oberseite, einer Mesa-Breite und einer Mesa-Höhe ausgebildet ist und die Unterseite der ersten Halbleiterkontaktschicht (16) auf oder oberhalb eines ersten Oberflächenabschnitts der Oberseite des Driftgebiets (12) mit einer mit der Mesa-Breite übereinstimmenden Breite angeordnet ist,
- eine Unterseite der ersten metallischen Anschlusskontaktschicht (20) stoffschlüssig mit der Oberseite der ersten Halbleiterkontaktschicht (16) verbunden ist und
- die zweite metallische Anschlusskontaktschicht (18) unterhalb einer Unterseite des Driftgebiets (12) angeordnet ist,
**dadurch gekennzeichnet, dass**
- die hochsperrende III-V-Halbleiterleistungsdiode (10) eine III-V-Halbleiterpassivierungsschicht (22) mit der ersten Gitterkonstanten aufweist, wobei
- die III-V-Halbleiterpassivierungsschicht (22) einen dem Leitfähigkeitstyp des Driftgebiets (12) entsprechenden Leitfähigkeitstyp oder einen von dem Leitfähigkeitstyp des Driftgebiets (12) abweichenden Leitfähigkeitstyp und eine Dotierstoffkonzentration von 1•10¹⁴ - 5•10¹⁸ cm⁻³ oder von 1•10¹⁴ - 1•10¹⁹ cm⁻³ und eine zweite Energiebandlücke aufweist,
- die III-V-Halbleiterpassivierungsschicht (22) in einem ersten Abstand (A1) von mindestens 0,1 µm oder von mindestens 0,5 µm oder von mindestens 1 µm oder von mindestens 20 µm oder von mindestens 40 µm zu der Mesa-Struktur der ersten Halbleiterkontaktschicht (16) auf der Oberseite des Driftgebiets (12) angeordnet und mit der Oberseite des Driftgebiets (12) stoffschlüssig verbunden ist.

2. Stapelförmige hochsperrende III-V-Halbleiterleistungsdiode (10) nach Anspruch 1, **dadurch gekennzeichnet, dass** die III-V-Halbleiterpassivierungsschicht (22) eine Schichtdicke (D22) von 0,02 µm - 1 µm oder von 0,02 µm - 10 µm aufweist.

3. Stapelförmige hochsperrende III-V-Halbleiterleistungsdiode (10) nach einem der vorangegangenen Ansprüche, **dadurch gekennzeichnet, dass** die III-V-Halbleiterpassivierungsschicht (22) InGaP oder AlGaAs oder InGaAsP oder InAlP oder InAlGaP aufweist oder aus InGaP oder aus AlGaAs oder aus InGaAsP oder aus InAlP oder aus InAlGaP besteht.

4. Stapelförmige hochsperrende III-V-Halbleiterleistungsdiode (10) nach einem der vorangegangenen Ansprüche, **dadurch gekennzeichnet, dass** der erste Abstand (A1) der III-V-Halbleiterpassivierungsschicht (22) zu der ersten Halbleiterkontaktschicht (16) mindestens 0,1% oder mindestens 2% oder mindestens 10% oder mindestens 50% oder mindestens 75% der Schichtdicke (D12) des Driftgebiets (12) beträgt.

5. Stapelförmige hochsperrende III-V-Halbleiterleistungsdiode (10) nach einem der vorangegangenen Ansprüche, **dadurch gekennzeichnet, dass** die III-V-Halbleiterpassivierungsschicht (22) in einer Projektion senkrecht zu der Oberseite der ersten Halbleiterkontaktschicht (16) die erste Halbleiterkontaktschicht (16) vollständig umschließt.

6. Stapelförmige hochsperrende III-V-Halbleiterleistungsdiode (10) nach einem der vorangegangenen Ansprüche, **dadurch gekennzeichnet, dass** die III-V-Halbleiterpassivierungsschicht (22) einen dem Driftgebiet (12) entsprechenden Leitfähigkeitstyp aufweist.

7. Stapelförmige hochsperrende III-V-Halbleiterleistungsdiode (10) nach einem der Ansprüche 1 bis 5, **dadurch gekennzeichnet, dass** das Driftgebiet (12) den ersten Leitfähigkeitstyp und die III-V-Halbleiterpassivierungsschicht (22) den zweiten Leitfähigkeitstyp aufweist und/oder eine zumindest gebietsweise ausgebildete dritte metallische Anschlusskontaktschicht (30) stoffschlüssig mit einer Oberseite der III-V-Halbleiterpassivierungsschicht (22) verbunden ist.

8. Stapelförmige hochsperrende III-V-Halbleiterleistungsdiode (10) nach einem der vorangegangenen Ansprüche, **dadurch gekennzeichnet, dass** die III-V-Halbleiterpassivierungsschicht (22) und/oder die erste Halbleiterkontaktschicht (16) und/oder das Driftgebiet (12) jeweils epitaktisch auf einer vorausgehenden Schicht der hochsperrenden III-V-Halbleiterleistungsdiode (10) erzeugt ist.

9. Stapelförmige hochsperrende III-V-Halbleiterleistungsdiode (10) nach einem der vorangegangenen Ansprüche, **dadurch gekennzeichnet, dass** die erste Halbleiterkontaktschicht (16) und das Driftgebiet (12) und/oder eine zweite Halbleiterkontaktschicht (14) GaAs aufweisen oder aus GaAs bestehen.

10. Stapelförmige hochsperrende III-V-Halbleiterleistungsdiode (10) nach einem der vorangegangenen Ansprüche, **dadurch gekennzeichnet, dass** die Mesa-Struktur einen kreisförmigen oder einen ovalen oder einen mehreckigen Umfang oder einen rechteckigen Umfang mit abgerundeten Kanten aufweist.

11. Stapelförmige hochsperrende III-V-Halbleiterleistungsdiode (10) nach einem der vorangegangenen Ansprüche, **dadurch gekennzeichnet, dass** der erste Leitfähigkeitstyp n ist und der zweite Leitfähigkeitstyp p ist oder dass der erste Leitfähigkeitstyp p ist und der zweite Leitfähigkeitstyp n ist.

12. Stapelförmige hochsperrende III-V-Halbleiterleistungsdiode (10) nach einem der vorangegangenen Ansprüche, **dadurch gekennzeichnet, dass** die stapelförmige hochsperrende III-V-Halbleiterleistungsdiode (10) eine Pufferschicht (32) aufweist, wobei die Pufferschicht (32) unterhalb der Unterseite des Driftgebiets (12) und oberhalb der zweiten metallischen Anschlusskontaktschicht (18) angeordnet ist und an einer dem Driftgebiet (12) zugewandten Oberseite die erste Gitterkonstante und an einer Unterseite eine von der ersten Gitterkonstanten abweichende zweite Gitterkonstante aufweist.

13. Stapelförmige hochsperrende III-V-Halbleiterleistungsdiode (10) nach einem der vorangegangenen Ansprüche, **dadurch gekennzeichnet, dass** die hochsperrende III-V-Halbleiterleistungsdiode (10) eine Substratschicht aufweist, wobei die Substratschicht unterhalb der Unterseite des Driftgebiets (12) und oberhalb der zweiten metallischen Anschlusskontaktschicht (18) angeordnet ist und die erste Gitterkonstante oder eine von der ersten Gitterkonstanten abweichende zweite Gitterkonstante aufweist.

14. Stapelförmige hochsperrende III-V-Halbleiterleistungsdiode (10) nach einem der vorangegangenen Ansprüche, **dadurch gekennzeichnet, dass** die hochsperrende III-V-Halbleiterleistungsdiode (10) eine zumindest gebietsweise ausgebildete Halbleiterzwischenschicht (24) mit einer Schichtdicke von höchstens 80 µm oder von höchstens 40 µm und einer Dotierstoffkonzentration von 8•10¹² - 1•10¹⁶ cm⁻³ aufweist, wobei die Halbleiterzwischenschicht (24) entweder den zweiten Leitfähigkeitstyp aufweisend unterhalb des Driftgebiets (12) und oberhalb einer zweiten hochdotierten Halbleiterkontaktschicht (14) angeordnet ist oder den ersten Leitfähigkeitstyp aufweisend oberhalb des Driftgebiets (12) und unterhalb der ersten Halbleiterkontaktschicht (16) angeordnet ist.

15. Stapelförmige hochsperrende III-V-Halbleiterleistungsdiode (10) nach einem der vorangegangenen Ansprüche, **dadurch gekennzeichnet, dass** das Driftgebiet (12) den zweiten Leitfähigkeitstyp aufweist und die zweite metallische Anschlusskontaktschicht (18) mit der Unterseite des Driftgebiets (12) oder mit einer Unterseite einer unterhalb des Driftgebiets (12) angeordneten Pufferschicht (32) oder mit einer Unterseite einer unterhalb des Driftgebiets (12) angeordneten Substratschicht stoffschlüssig verbunden ist.

16. Stapelförmige hochsperrende III-V-Halbleiterleistungsdiode (10) nach einem der Ansprüche 1 bis 14, **dadurch gekennzeichnet, dass** die hochsperrende III-V-Halbleiterleistungsdiode (10) eine hochdotierte zweite Halbleiterkontaktschicht (14) des zweiten Leitfähigkeitstyps mit einer Dotierstoffkonzentration von mindestens 1•10¹⁷ cm³ und der ersten Gitterkonstanten oder einer zweiten Gitterkonstanten aufweist, wobei die zweite Halbleiterkontaktschicht (14) unterhalb des Driftgebiets (12) angeordnet ist und die zweite metallische Anschlusskontaktschicht (18) stoffschlüssig mit einer Unterseite der zweiten Halbleiterkontaktschicht (14) verbunden ist.

17. Stapelförmige hochsperrende III-V-Halbleiterleistungsdiode (10) nach Anspruch 16, **dadurch gekennzeichnet, dass** die zweite Halbleiterkontaktschicht (14) eine Schichtdicke (D14) von 0,5 µm - 200 µm oder von 10 µm - 600 µm aufweist.

18. Stapelförmige hochsperrende III-V-Halbleiterleistungsdiode (10) nach einem der Ansprüche 16 oder 17, **dadurch gekennzeichnet, dass** die zweite Halbleiterkontaktschicht (14) die erste Gitterkonstante aufweist.

19. Stapelförmige hochsperrende III-V-Halbleiterleistungsdiode (10) nach Anspruch 18, **dadurch gekennzeichnet, dass** die Unterseite des Driftgebiets (12) stoffschlüssig mit der Oberseite der zweiten Halbleiterkontaktschicht (14) verbunden ist.

20. Stapelförmige hochsperrende III-V-Halbleiterleistungsdiode (10) nach einem der Ansprüche 16 oder 17, **dadurch gekennzeichnet, dass** die zweite Halbleiterkontaktschicht (14) die zweite Gitterkonstante aufweist und zwischen der zweiten Halbleiterkontaktschicht (14) und dem Driftgebiet (12) eine Pufferschicht mit der ersten Gitterkonstanten an einer dem Driftgebiet (12) zugewandten Oberseite und der zweiten Gitterkonstante an einer der zweiten Halbleiterkontaktschicht zugewandten Unterseite angeordnet ist.

21. Stapelförmige hochsperrende III-V-Halbleiterleistungsdiode (10) nach einem der Ansprüche 16 bis 20, **dadurch gekennzeichnet, dass** die zweite Halbleiterkontaktschicht (14) als Substratschicht oder als Pufferschicht (32) ausgebildet ist.

22. Stapelförmige hochsperrende III-V-Halbleiterleistungsdlode (10) nach einem der vorangegangenen Ansprüche, **dadurch gekennzeichnet, dass** die zweite Energiebandlücke der III-V-Halbleiterpassivierungsschicht (22) größer als die erste Energiebandlücke des Driftgebietes (12) ist.
